# EUROPEAN PATENT APPLICATION

(11) **EP 4 456 345 A1**
(43) Date of publication of application: **30.10.2024**
(21) Application number: 23749836.5
(22) Date of filing: 02.02.2023
(51) Int. Cl.: H01S 5/11

(54) **PHOTONIC-CRYSTAL SURFACE-LIGHT-EMITTING LASER ELEMENT**

(30) Priority: 03.02.2022 JP 2022015936
(71) Applicant: Kyoto University, Kyoto-shi, Kyoto 606-8501 (JP); Stanley Electric Co. Ltd., Tokyo 153-8636 (JP)
(72) Inventor: NODA Susumu, Kyoto-shi, Kyoto 606-8501 (JP); INOUE Takuya, Kyoto-shi, Kyoto 606-8501 (JP); EMOTO Kei, Tokyo 153-8636 (JP); KOIZUMI Tomoaki, Tokyo 153-8636 (JP)
(74) Representative: Schmidbauer, Andreas Konrad
(86) International application number: PCT/JP2023/003460
(87) International publication number: WO 2023/149520

(57) **Abstract**

A photonic-crystal surface-emitting laser element having a photonic crystal layer includes a first semiconductor layer in which the photonic crystal layer having air holes arranged with two-dimensional periodicity within a plane parallel to the layer is formed; an active layer formed on the first semiconductor layer; a second semiconductor layer formed on the active layer; a high-refractive-index layer that is formed on the second semiconductor layer and has, at a central region, an opening part exposing the second semiconductor layer; a transparent conductor layer that covers the second semiconductor layer exposed at the opening part, is electrically connected to the second semiconductor layer, and has a lower refractive index than the high-refractive-index layer; and a light-reflecting film that is provided on the transparent conductor layer and the high-refractive-index layer, and reflects light incident via the opening part and the second semiconductor layer.

## Description

### Technical Field

The present invention relates to a photonic-crystal surface-emitting laser element.

### Background Art

In recent years, the development of a photonic-crystal surface-emitting laser using a photonic-crystal (PC) has progressed.

For example, Non-Patent Literature 1 discloses an in-plane diffraction effect and a threshold gain difference of a photonic-crystal laser, and Non-Patent Literature 2 discloses a three-dimensional coupled wave model of a square lattice photonic-crystal laser.

In addition, a photonic-crystal surface-emitting laser having a multiple lattice photonic crystal which is configured by disposing a plurality of air holes having different sizes at lattice points is known.

For example, Patent Literature 1 describes a two-dimensional photonic-crystal surface-emitting laser light source having a two-dimensional photonic crystal in which a large number of different refractive index region aggregates are periodically arranged in a plate-shaped base material, in which the different refractive index region aggregate consists of a plurality of regions having different refractive indices from the refractive index of the base material, and at least two of the regions have different thicknesses from each other.

In addition, Non-Patent Literature 3 discloses that multimode oscillation causing beam quality to be deteriorated is suppressed by changing the air hole size or the lattice constant of a photonic crystal.

However, since the photonic crystal has very small air holes, it is difficult to accurately produce the size or the lattice constant of the air holes.

In such a two-dimensional photonic-crystal surface-emitting laser element, it is important to realize a laser element having high beam quality, which is stable even at the time of high current injection while suppressing a higher-order mode oscillation and maintaining a fundamental mode.

### Citation List

### Patent Literature

Patent Literature 1: Japanese Patent No. 4294023

### Non-Patent Literatures

Non-Patent Literature 1: Tanaka et al., Proceedings of The Japan Society of Applied Physics, Autumn Meeting 2016, 15p-B4-20
Non-Patent Literature 2: Y. Liang et al.: Phys. Rev. B vol. 84 (2011) 195119
Non-Patent Literature 3: M. Yoshida et al., Proceedings of the IEEE (2019). "Experimental Investigation of Lasing Modes in Double-Lattice Photonic-Crystal Resonators and Introduction of In-Plane Heterostructures."

### Summary of Invention

### Technical Problem

The present invention has been made on the basis of a finding obtained in that beam quality is deteriorated by a mechanism different from a pulse operation in a continuous oscillation operation or a continuous wave (CW) operation of a photonic-crystal surface-emitting laser element.

An object of the present invention is to provide a photonic-crystal surface-emitting laser element having high beam quality, which suppresses a higher-order mode oscillation and side lobes in the CW operation, maintains a fundamental mode until high current injection, and has stable transverse modes and longitudinal modes.

### Solution to Problem

A surface-emitting laser element according to one embodiment of the present invention is a photonic-crystal surface-emitting laser element having a photonic crystal layer, including:
a first semiconductor layer in which the photonic crystal layer having air holes arranged with two-dimensional periodicity within a plane parallel to the layer is formed;
an active layer formed on the first semiconductor layer;
a second semiconductor layer formed on the active layer;
a high-refractive-index layer that is formed on the second semiconductor layer and has, at a central region, an opening part exposing the second semiconductor layer;
a transparent conductor layer that covers the second semiconductor layer exposed at the opening part, is electrically connected to the second semiconductor layer, and has a lower refractive index than the high-refractive-index layer; and
a light-reflecting film that is provided on the transparent conductor layer and the high-refractive-index layer, and reflects light incident via the opening part and the second semiconductor layer.

### Brief Description of Drawings

FIG. 1A is a cross-sectional view schematically illustrating an example of a structure of a photonic-crystal laser element (PCSEL element) 10 of Example 1.
FIG. 1B is an enlarged cross-sectional view schematically illustrating a photonic crystal layer 14P in FIG. 1A and an air hole pair 14K arranged in the photonic crystal layer 14P.
FIG. 2A is a plan view schematically illustrating an upper surface of the PCSEL element 10.
FIG. 2B is a cross-sectional view schematically illustrating a cross-section of the photonic crystal layer 14P on a plane parallel to the n-guide layer 14 (cross-section taken along a line A-A in FIG. 1B).
FIG. 2C is a plan view schematically illustrating a bottom surface of the PCSEL element 10.
FIG. 3 is a plan view schematically illustrating air hole pairs 14K consisting of main air holes 14K1 and secondary air holes 14K2, which are arranged at a square lattice position within a plane of the photonic crystal layer 14P.
FIG. 4A is a view illustrating a calculation result of a far-field pattern (FFP) in a case where a constant current of 2 A is applied to the PCSEL element 10 of Example 1.
FIG. 4B is a view illustrating a calculation result of an oscillation spectrum in a case where a constant current of 2 A is applied to the PCSEL element 10 of Example 1.
FIG. 5A is a view illustrating a calculation result of a far-field pattern (FFP) in a case where a constant current of 2 A is applied to the PCSEL element of Comparative Example.
FIG. 5B is a graph illustrating a calculation result of an oscillation spectrum in a case where a constant current of 2 A is applied to the PCSEL element of Comparative Example.
FIG. 6 is a view illustrating photonic bands of Example 1 (EMB 1) and Comparative Example (CMP) at the time of no current injection and at the time of current injection (CW).
FIG. 7 is a cross-sectional view schematically illustrating an example of a structure of a PCSEL element 40 of Example 2 (EMB2).
FIG. 8 is a cross-sectional view schematically illustrating an example of a structure of a PCSEL element 50 of Example 3 (EMB3).

### Description of Embodiments

Hereinafter, preferred embodiments of the present invention will be described, but these embodiments may be appropriately modified and combined. In addition, in the following description and the accompanying drawings, substantially the same or equivalent parts will be described with the same reference numerals.

### Example 1

### [Structure of Photonic-Crystal Surface-Emitting Laser]

A photonic-crystal surface-emitting laser (hereinafter also referred to as a PCSEL) is an element that has a resonator layer parallel to a semiconductor light emitting structure layer (consisting of an n-guide layer, a light emitting layer, and a p-guide layer) constituting a light emitting element, and emits coherent light in the direction orthogonal to the resonator layer.

On the other hand, a distributed bragg reflector (DBR) laser having a pair of resonator mirrors (bragg reflectors) that interpose a semiconductor light emitting structure layer therebetween is known, but the photonic-crystal surface-emitting laser (PCSEL) differs from the DBR laser in terms of the following points. That is, in the photonic-crystal surface-emitting laser (PCSEL), a light wave propagating within a plane parallel to the photonic crystal layer is diffracted due to a diffraction effect of the photonic crystal to form a two-dimensional resonance mode, and is also diffracted in the direction perpendicular to the parallel plane. That is, a light extraction direction is a direction which is perpendicular to the resonance direction (within a plane parallel to the photonic crystal layer).

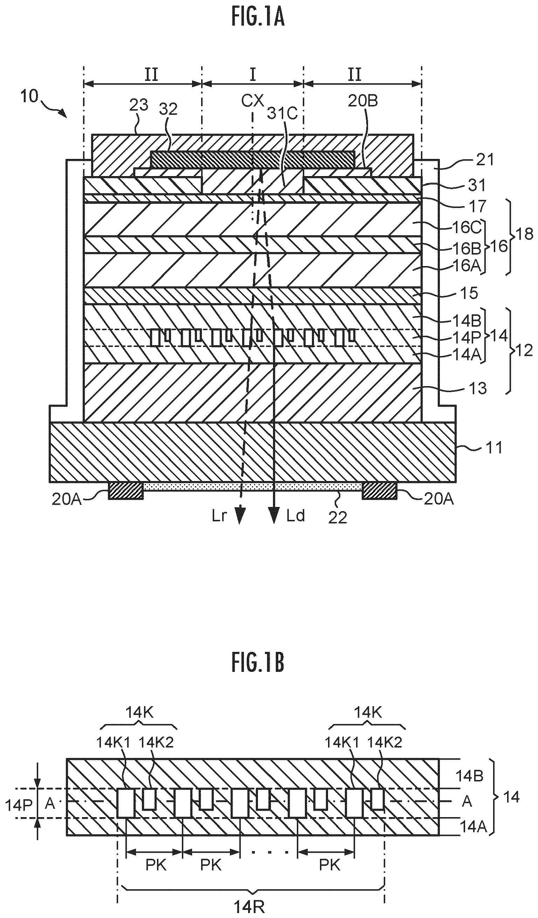

FIG. 1A is a cross-sectional view schematically illustrating an example of a structure of a photonic-crystal laser element (PCSEL element) 10 of Example 1. The PCSEL element 10 is configured such that a plurality of semiconductor layers is laminated on a substrate. The semiconductor layer consists of a hexagonal nitride semiconductor such as a GaN-based semiconductor, for example.

In addition, FIG. 1B is an enlarged cross-sectional view schematically illustrating a photonic crystal layer 14P in FIG. 1A and an air hole pair 14K arranged in the photonic crystal layer 14P.

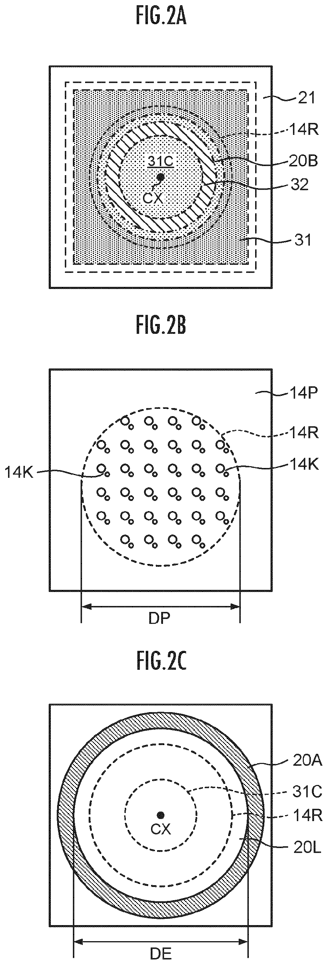

FIG. 2A is a plan view schematically illustrating an upper surface of the PCSEL element 10, FIG. 2B is a cross-sectional view schematically illustrating a cross-section of the photonic crystal layer (PC layer) 14P on a plane parallel to the n-guide layer 14 (a cross-section taken along the line A-A in FIG. 1B), and FIG. 2C is a plan view schematically illustrating a bottom surface of the PCSEL element 10.

The structure of the PCSEL element 10 will be described in detail below with reference to the accompanying drawings. In the PCSEL element 10, a first semiconductor layer 12, an active layer 15, and a second semiconductor layer 18 are formed by being laminated on a substrate 11.

The first semiconductor layer 12 consists of an n-clad layer (first clad layer) 13 and an n-guide layer (first guide layer) 14. In addition, the n-guide layer (first guide layer) 14 consists of a lower guide layer 14A, a photonic crystal layer (an air hole layer or a PC layer) 14P, and an embedded layer 14B. The photonic crystal layer 14P has air holes arranged with two-dimensional periodicity within a plane parallel to the layer.

The active layer 15 has a multiple quantum well structure (MQW structure) in which a GaN barrier layer and an InₓGa_{y}N (x + y = 1) well layer are alternately laminated.

The second semiconductor layer 18 is composed of a p-guide layer (second guide layer) 16A provided on the active layer 15, an electron blocking layer (EBL) 16B provided on the p-guide layer 16A, a p-clad layer (second clad layer) 16C provided on the electron blocking layer 16B, and a p-contact layer 17 formed on the p-clad layer 16C. The p-guide layer 16A, the electron blocking layer 16B, and the p-clad layer 16C constitute the p-side semiconductor layer 16.

The p-contact layer 17 is a semiconductor layer that improves ohmic contact properties with the p-electrode, and is formed of a semiconductor layer having a smaller energy bandgap and/or a semiconductor layer having a higher impurity concentration, than the p-clad layer 16C.

That is, the first semiconductor layer 12 includes a semiconductor layer of a first conductive type (for example, n-type), and the second semiconductor layer 18 includes a semiconductor layer of a second conductive type (for example, p-type), which is a conductive type opposite to the first conductive type.

In the present specification, a case where the first conductive type is the n-type and the second conductive type which is a conductive type opposite to the first conductive type is the p-type is described, but the first conductive type and the second conductive type may be the p-type and the n-type, respectively.

Furthermore, in the present specification, "n-" and "p-" mean "n-side" and "p-side", respectively, and do not necessarily mean that the layer has an n-type or a p-type. For example, the n guide layer means a guide layer provided closer to the n-side than the active layer, and may be an undoped layer (or an i layer).

In addition, the n-clad layer 13 may include a plurality of layers instead of a single layer, and in this case, all the layers need not be n layers (n-doped layers), and may include an undoped layer (i layer). The same applies to the second semiconductor layer 18.

In addition, in the description above, the specific and detailed configuration of the semiconductor layer of the photonic-crystal laser element 10 has been described, but the description is merely an example of the element structure. In brief, the photonic-crystal laser element may be configured to have the first semiconductor layer having the photonic crystal layer 14P, the second semiconductor layer, and the active layer (light emitting layer) interposed therebetween, in which light is emitted by current injection into the active layer.

For example, the photonic-crystal laser element does not need to include all of the semiconductor layers described above. Alternatively, the photonic-crystal laser element may have various semiconductor layers (for example, an air hole blocking layer, a light confinement layer, a current confinement layer, and a tunnel junction layer) for improving the element characteristics.

In addition, an annular n-electrode (cathode) 20A (first electrode) is formed on the back surface of the substrate 11, and an antireflection film 22 is provided on the inner side of an n-electrode 20A on the back surface of the substrate 11 which is the laser light emitting surface.

A resonance frequency adjustment film (high-refractive-index layer) 31 is provided on an upper surface of the p-contact layer 17. As illustrated in FIG. 2A, the resonance frequency adjustment film 31 has a circular (cylindrical) opening part 31C having an axis CX as the central axis, and the surface of the p-contact layer 17 is exposed from the opening part 31C. Incidentally, the opening part 31C may have an elliptic shape in a top view.

In the opening part 31C, a p-electrode 20B (second electrode) which is a transparent electrode in which the opening part 31C is embedded is formed. That is, the p-electrode 20B covers the p-contact layer 17 exposed from the opening part 31C and is connected to the p-contact layer 17 by ohmic contact.

The p-electrode 20B is formed as a transparent conductor layer having a lower refractive index than the resonance frequency adjustment film (high-refractive-index layer) 31.

In the present Example, the p-electrode 20B is formed to coat the upper surface at an end part of the resonance frequency adjustment film 31 and has a circular shape in a case of being viewed from the above along the central axis CX (top view).

A light-reflecting film (hereinafter simply referred to as a reflective film) 32 is provided on the p-electrode 20B. The reflective film 32 has a similar shape to the opening part 31C and has a larger area than the opening part 31C, coaxially with the central axis CX of the opening part 31C, in a top view. That is, the reflective film 32 has a size including the opening part 31C and has a circular shape in the present Example, in a top view.

Furthermore, the reflective film 32 may be provided on the p-electrode 20B which is a transparent conductor layer, and on a part of the resonance frequency adjustment film (high-refractive-index layer) 31 (that is, a part around the opening part 31C). However, as illustrated in FIG. 1A, in a case where the p-electrode 20B has a coating part that coats the upper surface at an end part of the resonance frequency adjustment film 31, the coating part of the p-electrode 20B may be formed by being interposed between the reflective film 32 and the resonance frequency adjustment film 31.

In addition, the reflective film 32 is provided to cover at least the entire opening part 31C in a top view, and preferably has a size equal to or larger than an effective diameter (beam diameter) of the laser light. For example, it is preferable that the reflective film 32 has a circular shape coaxial with the central axis CX and has a size equal to or larger than a Gaussian beam diameter (a diameter at which the light intensity is 1/e² of the peak).

A pad electrode 23 electrically connected to the p-electrode 20B is formed on the reflective film 32. The pad electrode 23 is formed such that the p-electrodes 20B and the reflective film 32 are embedded. Incidentally, in FIG. 2A, the pad electrode 23 is not illustrated.

The side surfaces of the laminated semiconductor layers (that is, the first semiconductor layer 12, the active layer 15, and the second semiconductor layer 18), and the side surface and the end part of the upper surface of the resonance frequency adjustment film 31 are coated with a protective film 21 made of an insulator such as SiO₂. Incidentally, for the sake of clarity of the drawings, the protective film 21 is not hatched.

Light directly emitted from the photonic crystal layer 14P (directly emitted light Ld), and light emitted from the photonic crystal layer 14P, transmitted through the p-electrode 20B and the resonance frequency adjustment film 31, and reflected by the reflective film 32 (reflected emitted light Lr) are emitted to the outside from a light emission region 20L on the back surface of the substrate 11.

As illustrated in FIG. 1B, in the present Example, the photonic crystal layer 14P has a double-lattice structure. That is, the air hole pair 14K (the main air hole 14K1 and the secondary air hole 14K2) is formed by being embedded in the n-guide layer 14 in a two-dimensional arrangement at square lattice point positions having a period PK in a crystal growth surface (semiconductor layer growth surface), that is, a plane parallel to the n-guide layer 14 (the cross-section of A-Ain the drawing). Incidentally, the photonic crystal layer 14P is not limited to the double-lattice structure, and may have a single lattice structure or a multiple lattice structure.

As illustrated in FIG. 2B, in the photonic crystal layer 14P, the air hole pairs 14K are provided, for example, by being arranged periodically in a circular air hole formation region 14R. As illustrated in FIG. 2C, the n-electrode (cathode) 20A is provided as an annular electrode outside the air hole formation region 14R not to overlap the air hole formation region 14R in a case of being viewed from the direction perpendicular to the photonic crystal layer 14P (that is, in a top view). A region inside the n-electrode 20A is the light emission region 20L.

In addition, as illustrated in FIGS. 2B and 2C, the annular n-electrode 20A is formed to be coaxial with the opening part 31C and the air hole formation region 14R of the resonance frequency adjustment film 31, and a diameter DP of the air hole formation region 14R is smaller than an inner diameter DE of the n-electrode 20A (DP < DE).

### [Specific Configuration of Each Layer of PCSEL Element 10]

Hereinafter, details of each layer of the PCSEL element 10 will be described. The characteristic simulation of the element described below was performed based on the following detailed configuration. However, the composition, the layer thickness, and the like of each layer of the PCSEL element 10 are merely examples, and can be modified and applied as appropriate without being particularly limited.

### (1) Substrate

The substrate 11 is a hexagonal GaN single crystal substrate having a high transmittance to light emitted from the active layer 15, and is a growth substrate. More specifically, the substrate 11 is a GaN single crystal whose main surface is a "+c" surface which is a (0001) surface having Ga atoms arranged on the outermost surface.

Furthermore, the main surface may be a just substrate which is not offset, or may be, for example, a substrate which is offset by about 1° in the m-axis direction. For example, a substrate which is offset by about 1° in the m-axis direction can obtain mirror growth under a wide range of growth conditions.

A substrate surface (back surface) provided with the light emission region 20L opposite to the main surface is a "-c" surface which is a (000-1) surface where N atoms are arranged on the outermost surface. The -c surface is resistant to oxidation or the like, and is thus suitable as a light extraction surface.

In the present Example, the GaN substrate 11 is a substrate made of an n-type GaN single crystal, and has a function as a contact layer with the n-electrode.

The n-clad layer 13 is an n-type Al_{0.04}Ga_{0.96}N layer (layer thickness: 2 µm) having an Al composition of 4%. In addition, the carrier concentration of the n-clad layer 13 at room temperature is 1 x 10¹⁸ cm⁻³. The n-clad layer may have an Al composition of 2% to 10% and a thickness of 1 to 3 µm.

### (2) n-Guide Layer

The lower guide layer 14A of the n-guide layer 14 is n-type GaN and has a layer thickness of 300 nm. The lower guide layer 14A may have a layer thickness of, for example, 20 to 500 nm. In addition, the carrier concentration of the lower guide layer 14A at room temperature is 1 x 10¹⁸ cm⁻³.

The photonic crystal layer 14P on the lower guide layer 14A includes regularly arranged air holes that resonate, in a horizontal plane, light emitted from the active layer 15.

The photonic crystal layer 14P is an undoped GaN layer and has a layer thickness of 100 nm. The photonic crystal layer 14P may have a layer thickness of, for example, 60 to 150 nm. Incidentally, the air holes of the photonic crystal layer 14P will be described in detail later with reference to the drawings.

The embedded layer 14B on the photonic crystal layer 14P is an undoped GaN layer and has a layer thickness of 100 nm. Incidentally, the embedded layer 14B may be, for example, a layer consisting of n-GaN or n-InGaN, or a layer consisting of undoped GaN or undoped InGaN, having a thickness of 50 to 150 nm.

### (2.1) Photonic Crystal Layer

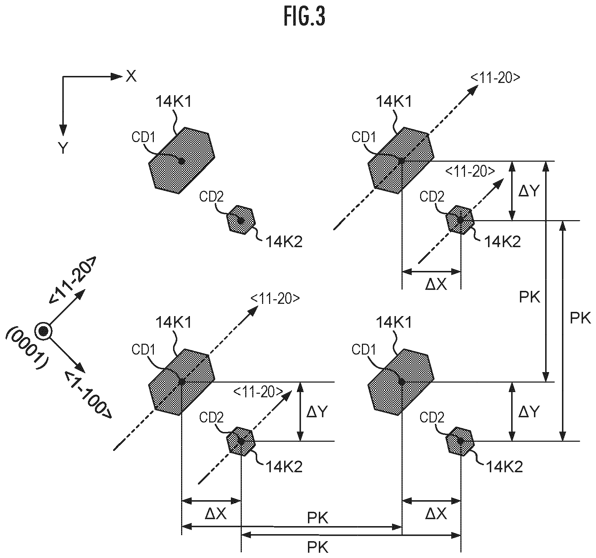

FIG. 3 is a plan view schematically illustrating air hole pairs 14K consisting of main air holes 14K1 and secondary air holes 14K2, which are arranged at a square lattice position within a plane of the photonic crystal layer 14P, in a case of being viewed from the upper surface. That is, the photonic crystal layer 14P has a double-lattice structure. Incidentally, for the sake of clarity in the drawing, the main air holes 14K1 and the secondary air holes 14K2 are hatched.

More specifically, the main air holes 14K1 are arranged at square lattice positions with a period PK in two directions (x-direction and y-direction) in which centers CD1 of gravity are orthogonal to each other. Similarly, the centers CD2 of gravity of the secondary air holes 14K2 are arranged at square lattice positions with the period PK in the x-direction and the y-direction. Specifically, the period PK was set to 179 nm. An oscillation wavelength of the present Example was about 441 nm. Here, the period PK may be appropriately adjusted according to a gain wavelength emitted from the active layer.

The main air hole 14K1 has a long hexagonal shape surrounded by the m surface which is a { 10-10} surface in a top view (that is, in a case of being viewed from the direction perpendicular to the photonic crystal layer 14P). The secondary air hole 14K2 also has a shape surrounded by the m surface.

Furthermore, the x-direction and the y-direction are directions inclined by 45° with respect to the major axis direction (<11-20> direction) and the minor axis direction (<1-100> direction) of the main air hole 14K1, respectively. In the present specification, the x-y coordinate is also referred to as an air hole coordinate.

In addition, the center CD2 of gravity of the secondary air hole 14K2 is separated from the center CD1 of gravity of the main air hole 14K1 by Δx in the x direction and Δy in the y direction. Here, Δx = Δy was set. That is, the center CD2 of gravity of the secondary air hole 14K2 is separated from the center CD1 of gravity of the main air hole 14K1 in the <1-100> direction. Specifically, the distance Δx between the centers of gravity in the x direction and the distance Δy between the centers of gravity in the y direction were set to 82.8 nm. Here, the distance Δx between the centers of gravity in the x direction and the distance Δy between the centers of gravity in the y direction may be appropriately adjusted according to the laser characteristics, such as a current value required for a device to which a laser element is applied and a slope efficiency of an emission intensity of the laser.

### (3) Active Layer

The active layer 15 has a multiple quantum well structure (MQW structure) in which a GaN barrier layer having a thickness of 6 nm and an In_{0.14}Ga_{0.86}N (x + y = 1) well layer having a thickness of 4.0 nm are alternately laminated. In the present Example, a well layer having a two-layer quantum well structure was used.

The active layer 15 was disposed within 180 nm from the air hole layer (photonic crystal layer 14P) with a distance at which a resonance effect by the air hole layer was sufficiently obtained.

### (4) Second Semiconductor Layer

The p-guide layer 16A of the second semiconductor layer 18 is an undoped InGaN layer having a layer thickness of 250 nm. The p-guide layer 16A may have a layer thickness of 100 to 500 nm and may be an AIInGaN layer of an undoped.

In addition, the p-guide layer 16A is an undoped layer in consideration of light absorption by the dopant, but for example, magnesium (Mg) may be doped in order to obtain satisfactory electrical conductivity.

An electron blocking layer (EBL) 16B provided on the p-guide layer 16A is a magnesium-doped p-type Al_{0.20}Ga_{0.80}N layer with a layer thickness of 15 nm and an Al composition of 20%.

The aluminum (Al) composition of EBL16B was set to have a composition that can serve as a barrier (energy difference) capable of preventing electrons, which are carriers, from flowing into the p-clad layer 16C. Here, the EBL16B may be a multilayer structure in which the Al concentration is changed, in addition to AlGaN having a constant Al concentration.

The p-clad layer 16C has a layer thickness of 100 nm and is magnesium-doped p-type Al_{0.06}Ga_{0.94}N. The p-clad layer 16C may have an Al composition of 2% to 10% and a layer thickness of 100 to 350 nm.

In addition, in the present Example, the p-contact layer 17 is provided on the p-clad layer 16C. The p-contact layer 17 had a layer thickness of 25 nm and was magnesium-doped p-type GaN. The carrier concentration of the p-contact layer 17 was set to a concentration at which the layer could be ohmically bonded to the anode electrode provided on a surface thereof.

Further, an InGaN layer having a layer thickness of 2 nm or less, or an Si- or O-doped p-type GaN layer having a layer thickness of 2 nm or less may be provided on the outermost surface. By adding such a layer, the contact resistance of the p-electrode can be reduced.

### (5) Resonance Frequency Adjustment Film (High-Refractive-Index Layer)

The resonance frequency adjustment film (high-refractive-index layer) 31 has a higher refractive index than the p-electrode 20B which is a transparent electrode, and is formed of a transparent and insulating material with respect to the oscillation wavelength of the active layer 15. The resonance frequency adjustment film 31 can be formed by depositing ZrO2 using a sputtering method.

In the resonance frequency adjustment film 31, a cylindrical (diameter of 300 µmϕ) opening part 31C having the axis CX as a central axis is formed. The opening part 31C can be formed by a well-known method such as chemical etching or dry etching of a ZrO2 film.

Furthermore, a method for forming the resonance frequency adjustment film 31 is not limited to the sputtering method, and a CVD method, an electron beam vapor deposition method, an ALD method, an ion plating method, or the like can be used.

In addition, as the resonance frequency adjustment film 31, an insulating light-transmitting dielectric layer such as ZrO₂, TiO₂, Ta₂O₅, Nb₂O₅, and SiNₓ can be used.

Alternatively, a semiconductor layer such as GaN, AlGaN, InGaN, AlInGaN, and AlN can also be used. In this case, the semiconductor layer is set to be of a conductive type (that is, p-type) opposite to the semiconductor layer (n-type) as an underlayer, or the semiconductor layer is set to be insulating by ion implantation or the like.

Furthermore, the refractive index of the p-electrode 20B (ITO) is about 2.0, and the refractive indices of the light-transmitting dielectric layers may be shown as follows: ZrO₂ (2.26), TiO₂ (2.26), Ta₂O₅ (2.21), Nb₂O₅ (2.32), and SiNₓ (2.46) (the parentheses are the refractive indices at a wavelength λ = 440 nm).

In addition, the semiconductor layer varies depending on the composition, but the refractive index may be exemplified as follows: GaN (2.46), Al_{0.1}Ga_{0.9}N (2.40), In_{0.1}Ga_{0.9}N (2.60), and AlN (2.18) (the parentheses are the refractive indices at a wavelength λ = 440 nm).

As described above, as the resonance frequency adjustment film 31, the light-transmitting dielectric layer or light-transmitting semiconductor layer having a higher refractive index than the p-electrode 20B can be used.

Furthermore, the light-transmitting dielectric layer or light-transmitting semiconductor layer described above may be used as a single layer, but a layer obtained by laminating a plurality of these layers can be used as the resonance frequency adjustment film 31. In addition, the layer may include at least one layer or a plurality of layers.

In addition, a light-transmitting dielectric layer such as SiO₂ may be further provided on the light-transmitting dielectric layer and/or light-transmitting semiconductor layer described above.

### (6) p-Electrode (Anode Electrode)

Indium tin oxide (ITO) which is a transparent conductor was used as the p-electrode 20B. ITO can be formed by a sputtering method. In addition, the p-electrode 20B has a thickness of 135 nm and is formed to fill the opening part 31C.

Furthermore, the ITO film is preferably crystallized and heated by a lamp heating method in a nitrogen gas atmosphere to which oxygen has been added, for the purpose of reducing contact resistance and attaining transparency.

As the p-electrode 20B, a transparent conductor such as ZnO or GZO (Ga-doped ZnO) can be used in addition to ITO.

The p-electrode 20B is in ohmic contact with the p-contact layer 17. The thickness is preferably in a range of 50 nm to 300 nm. The thickness is preferably 50 nm or more in order to function as a cladding (light confinement) since in a case where the thickness is too large, the stress is large, the peeling easily occurs, and the absorption loss increases.

### (7) Reflective Film

Ag (silver) having a film thickness of 300 µm was used as the reflective film 32 on the p-electrode 20B. The reflective film 32 has a circular shape having a diameter of 350 µm with the axis CX as a center.

As the material of the reflective film 32, a material having a high reflectivity with respect to laser light is preferable, and for example, a metal such as Ag, Al, Rh, Pd, and Pt, or an alloy based on these materials can be used. In addition, for example, a dielectric DBR in which SiO₂/Ta₂O₅ or the like is laminated in a multi-layered manner can be used. Further, the dielectric DBR and the highly reflective metal film may be combined.

### (8) Pad Electrode

A pad electrode 23 electrically connected to the p-electrode 20B is formed on the reflective film 32. The pad electrode 23 consists of Ni/Pd/Au having thicknesses of 10 nm, 200 nm, and 500 nm (Au is the outermost surface), respectively, and is formed such that the p-electrode 20B and the reflective film 32 are embedded.

The pad electrode 23 has a rectangular shape of 700 µm x 700 µm in a top view. Furthermore, the outer shape of the PCSEL element 10 also has a rectangular columnar shape of about 800 µm x 800 µm.

### (9) n-Electrode (Cathode Electrode)

The n-electrode 20A consists of Ti/Pt/Au (Au is the outermost surface) and is in ohmic contact with the growth substrate 11. As the electrode material, Ti/Al, Ti/Rh, Ti/Al/Pt/Au, Ti/Au, V/Al/Au, V/Rh/Au, V/Al/Pt/Au, V/Pt/Au, or the like can be selected in addition to Ti/Pt/Au. It is preferable that the outermost surface is Au for wire bonding of Au.

### (10) Protective Film

The protective film 21 protects the crystal layer including aluminum (Al) constituting the PCSEL from a corrosive gas or the like. In addition, the present invention also protects against a short circuit and the like caused by the adhesion of foreign matters or the creeping of a solder at the time of mounting, and improves reliability and a yield. The material is not limited to SiO₂, and ZrO₂, HfO₂, TiO₂, Al₂O₃, or the like can be selected.

### [Characteristics of PCSEL Element 10]

The results of the characteristic simulation of the PCSEL element 10 of Example 1 will be described below in comparison with the PCSEL element of Comparative Example. Furthermore, the PCSEL element of Comparative Example has the same structure as the PCSEL element 10 of Example 1, except that the material used as the resonance frequency adjustment film 31 is different.

That is, in Example 1, a material having a higher refractive index than the p-electrode 20B is used as the resonance frequency adjustment film 31, but in Comparative Example, SiO₂, which is a material having a lower refractive index than the p-electrode 20B, is used.

In this simulation, heat generation is considered in a current injection region, a refractive index distribution corresponding to the heat generation is provided, and an effective refractive index is set. The effective refractive index adjusted by the resonance frequency adjustment film 31 was set in a region outside the current injection region and subjected to calculation. For the heat generation, a center peak temperature was set to about 50°C.

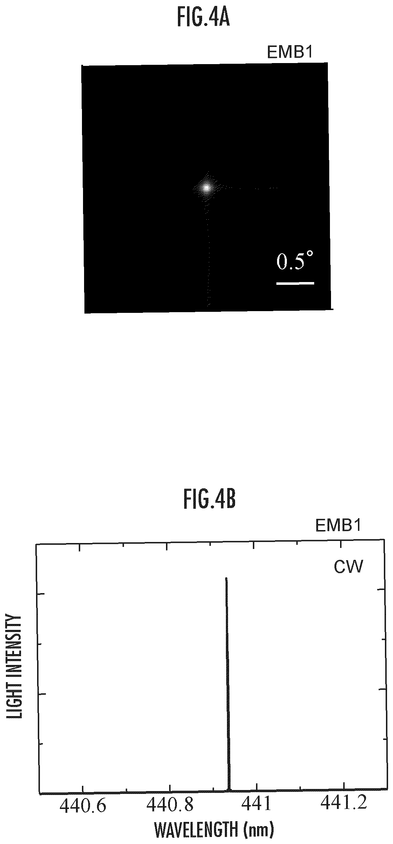

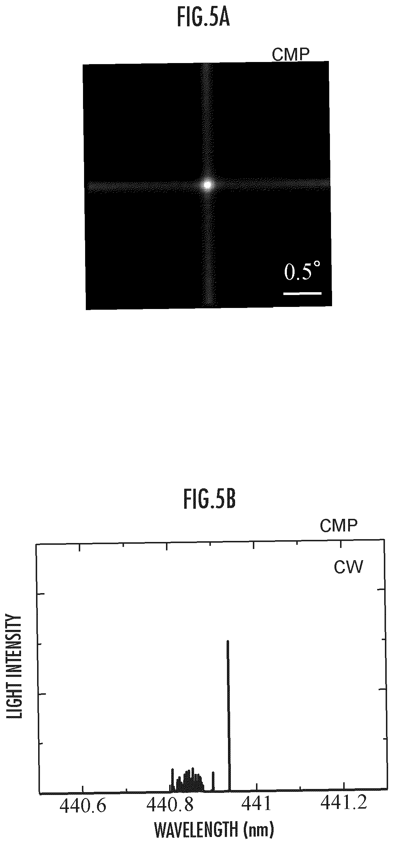

FIGS. 4A and 4B each illustrate the calculation results of a far-field pattern (FFP) and an oscillation spectrum in a case where a constant current of 2 A (Amperes) is applied to the PCSEL element 10 of Example 1. In addition, FIG. 5A and FIG. 5B each illustrate the calculation results of a far-field pattern (FFP) and an oscillation spectrum in a case where a constant current of 2 A (amperes) is applied to the PCSEL element of Comparative Example.

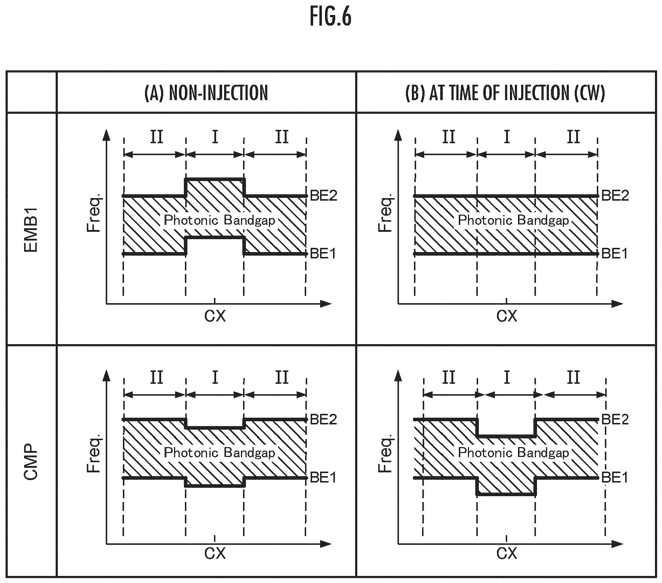

In addition, FIG. 6 is a view illustrating photonic bands of Example 1 (EMB1) and Comparative Example (CMP) at the time of no current injection and at the time of current injection (CW). A gap between the band edges BE1 and BE2 is a photonic bandgap (PBG). Furthermore, a region I (central region) corresponds to the opening part 31C, that is, a contact part between the p-electrode 20B and the p-contact layer 17, and a region II (peripheral region) corresponds to a part where the resonance frequency adjustment film 31 is formed.

The far-field patterns, which are beam characteristics, at a current of 2 A in Example 1 and Comparative Example are compared with reference to FIGS. 4A and 5A. In Example 1, a far-field pattern having a narrow spread angle was observed. On the other hand, in Comparative Example, cross-shaped side lobes appeared around a beam having a narrow spread angle.

As illustrated in FIG. 6, it is considered that this is an effect of a significant decrease in the band edge frequency in the region I, which is the current injection region, due to the heat generation of the current injection region in Comparative Example (CMP).

On the other hand, during the current injection, in the semiconductor layer corresponding to the region I which is the current injection region, the carrier density is increased and the refractive index is decreased, as compared with the semiconductor layer in the region II which is the peripheral region. As a result, a phenomenon in which the band edge frequency of the region I increases occurs at the same time. However, the increase in the refractive index due to the heat generation of the CW operation greatly affects the band edge frequency, as compared with the decrease in the refractive index due to the increase in the carrier density. As a result, the inventors have considered that the band edge frequency of the region I was significantly decreased.

More specifically, in Comparative Example, since an SiO2 film having a lower refractive index than ITO is formed on the periphery, the photonic band of the current injection region or the central region (region I) is in a state of being decreased from the time of current non-injection.

In addition, at the time of current injection, the photonic band frequency is decreased due to the heat generation to promote the current injection, and largely deviates from the photonic band frequency of the peripheral region (region II). With a positional relationship of this photonic band, it is considered that the in-plane light confinement is significantly weakened, a threshold gain of a mode in which a narrow spread angle oscillates increases, and a mode in which the angle oscillates in a cross shape appears.

On the other hand, in a case of Examples, due to the appropriate photonic band frequency relationship, it is considered that single-mode oscillation can be achieved without deteriorating the threshold gain of a beam with a narrow spread angle.

With reference to the oscillation spectra of Example 1 and Comparative Example, each illustrated in FIGS. 4B and 5B, it can be seen that Example 1 shows a longitudinal single-mode oscillation, whereas Comparative Example shows a longitudinal multi-mode oscillation. Furthermore, a spectrum near 440.85 nm in Comparative Example corresponds to the spectrum of a beam (FIG. 5A) extending crosswise.

Therefore, it is possible to provide a photonic-crystal surface-emitting laser element having high beam quality, which suppresses a higher-order mode oscillation and side lobes in the CW operation, maintains a fundamental mode until high current injection, and has stable transverse modes and longitudinal modes.

### Example 2

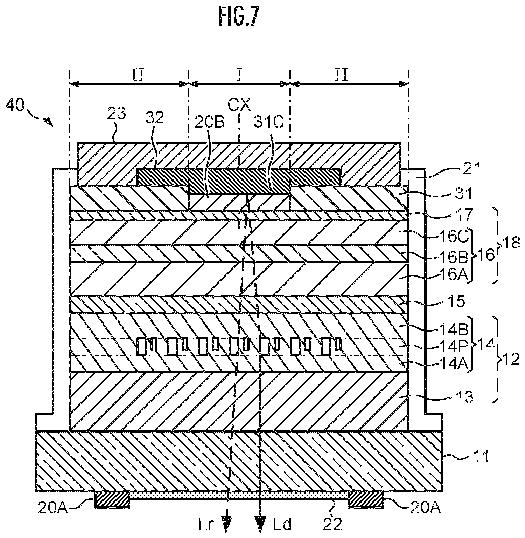

FIG. 7 is a cross-sectional view schematically illustrating an example of a structure of a PCSEL element 40 of Example 2 (EMB2).

The PCSEL element 40 is different from the PCSEL element 10 of Example 1 in that it has the resonance frequency adjustment film 31 having a larger thickness than the p-electrode 20B. The layer configuration of a semiconductor light emitting structure layer consisting of a first semiconductor layer 12, an active layer 15, and a second semiconductor layer 18 is the same as in the PCSEL element 10 of Example 1.

More specifically, the p-electrode 20B having a smaller refractive index than the resonance frequency adjustment film 31 has a smaller thickness than the resonance frequency adjustment film 31, and is formed on the p-contact layer 17. In addition, the p-electrode 20B is formed by being embedded in the opening part 31C by the reflective film 32.

In other words, also in the present Example, the p-electrode 20B which is a transparent conductor layer is provided in the opening part 31C which is a central region of the upper surface of the semiconductor light emitting structure layer, and the resonance frequency adjustment film 31 having a higher refractive index than the transparent conductor layer is provided in the peripheral region.

According to the PCSEL element 40 of Example 2, the optical path length in the direction perpendicular to the semiconductor light emitting structure layer in the region of the resonance frequency adjustment film 31 (the region II or the peripheral region) is longer than that in the region I (the central region), and thus, the adjustment range can be increased. Therefore, it is possible to improve the stability of the transverse mode and the longitudinal mode at the time of the CW operation.

### Example 3

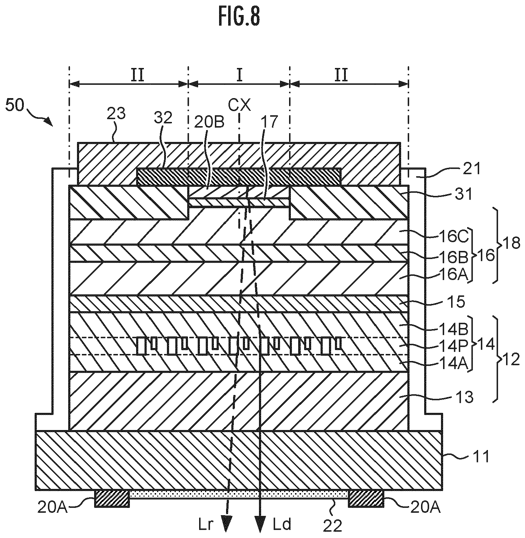

FIG. 8 is a cross-sectional view schematically illustrating an example of a structure of a PCSEL element 50 of Example 3 (EMB3).

The PCSEL element 50 is different from the PCSEL element 10 of Example 1 and the PCSEL element 40 of Example 2 in that it has the resonance frequency adjustment film 31 which reaches the inside of the p-clad layer 16C. The layer configuration of a semiconductor light emitting structure layer consisting of a first semiconductor layer 12, an active layer 15, and a second semiconductor layer 18 is the same as in the PCSEL element 10 of Example 1.

More specifically, the resonance frequency adjustment film 31 reaches the inside of the p-clad layer 16C, and a part of the p-clad layer 16C, the p-contact layer 17, and the p-electrode 20B are formed by being embedded in the opening part 31C by the reflective film 32.

Furthermore, the structure of the present Example can be realized by etching the p-contact layer 17 and the p-clad layer 16C in a region excluding the central region (region I) to form the resonance frequency adjustment film 31 in the region (region II).

In other words, also in the present Example, the p-electrode 20B which is a transparent conductor layer is provided in the opening part 31C which is a central region of the upper surface of the semiconductor light emitting structure layer, and the resonance frequency adjustment film 31 having a higher refractive index than the transparent conductor layer is provided in the peripheral region.

According to the PCSEL element 50 of Example 3, the optical path length in the direction perpendicular to the semiconductor light emitting structure layer in the region of the resonance frequency adjustment film 31 (the region II or the peripheral region) is longer than that in the region I (the central region), and thus, the adjustment range can be increased. Therefore, it is possible to improve the stability of the transverse mode and the longitudinal mode at the time of the CW operation.

Furthermore, in Examples described above, a case where the resonance frequency adjustment film (region II: high-refractive-index region) having an opening part with a circular shape (including an elliptical shape) in a top view is formed has been described as an example, but the present invention is not limited thereto. A region of the opening part (low-refractive-index region: region I) may have an n-gonal shape (n is an integer of 4 or more). In this case, it is preferable to have a polygonal shape of a hexagonal or higher shape (6 ≤ n).

In addition, it is preferable that the opening part (region I) of the resonance frequency adjustment film has a rotationally symmetrical shape with respect to the central axis CX. For example, in a case where the opening part has a polygonal shape in a top view, it is preferable that the opening part has a regular polygonal shape.

Moreover, a case where the opening part has a columnar shape has been described as an example, but the present invention is not limited thereto, and the opening part may have a truncated conical shape, a polygonal truncated pyramid shape, or the like. In addition, in a case of having a polygonal truncated pyramid shape, it is preferable that the opening part has a regular polygonal truncated pyramid shape.

As described above in detail, according to the present invention, it is possible to provide a photonic-crystal surface-emitting laser element having high beam quality, which suppresses a higher-order mode oscillation and side lobes in the CW operation, maintains a fundamental mode until high current injection, and has stable transverse modes and longitudinal modes.

### Description of Reference Numerals

10, 40, 50: PCSEL element
11: substrate
12: first semiconductor layer
13: first clad layer
14: first guide layer
14A: lower guide layer
14P: photonic crystal layer
14B: embedded layer
15: active layer
16A: second guide layer
16B: electron blocking layer
16C: second clad layer
17: contact layer
18: second semiconductor layer
20A: first electrode
20B: light-transmitting electrode (second electrode)
20L: light emission region
21: protective film
23: pad electrode
31C: opening part
31: resonance frequency adjustment film (high-refractive-index layer)

## Claims

1. A photonic-crystal surface-emitting laser element having a photonic crystal layer, comprising:
a first semiconductor layer in which the photonic crystal layer having air holes arranged with two-dimensional periodicity within a plane parallel to the layer is formed;
an active layer formed on the first semiconductor layer;
a second semiconductor layer formed on the active layer;
a high-refractive-index layer that is formed on the second semiconductor layer and has, at a central region, an opening part exposing the second semiconductor layer;
a transparent conductor layer that covers the second semiconductor layer exposed at the opening part, is electrically connected to the second semiconductor layer, and has a lower refractive index than the high-refractive-index layer; and
a light-reflecting film that is provided on the transparent conductor layer and the high-refractive-index layer, and reflects light incident via the opening part and the second semiconductor layer.

2. The photonic-crystal surface-emitting laser element according to claim 1,
wherein the transparent conductor layer fills the opening part, and
the light-reflecting film has a similar shape to the opening part and has a larger area than the opening part, coaxially with the opening part, in a case of being viewed from a direction perpendicular to the photonic crystal layer.

3. The photonic-crystal surface-emitting laser element according to claim 1,
wherein the high-refractive-index layer has a larger layer thickness than the transparent conductor layer,
the transparent conductor layer is embedded in the opening part by the light-reflecting film, and
the light-reflecting film has a similar shape to the opening part and has a larger area than the opening part in a case of being viewed from a direction perpendicular to the photonic crystal layer, coaxially with the opening part.

4. The photonic-crystal surface-emitting laser element according to claim 1,
wherein the high-refractive-index layer is formed at a depth reaching an inside of the second semiconductor layer from a surface side of the second semiconductor layer,
a part of the surface side of the second semiconductor layer is embedded in the opening part of the high-refractive-index layer by the transparent conductor layer, and
the light-reflecting film has a similar shape to the opening part and has a larger area than the opening part in a case of being viewed from a direction perpendicular to the photonic crystal layer, coaxially with the opening part.

5. The photonic-crystal surface-emitting laser element according to any one of claims 1 to 4,
wherein the opening part has a circular shape in a case of being viewed from a direction perpendicular to the photonic crystal layer.

6. The photonic-crystal surface-emitting laser element according to any one of claims 1 to 5,
wherein the high-refractive-index layer includes at least one layer of a ZrO₂ layer, a TiO₂ layer, a Ta₂O₅ layer, an Nb₂O₅ layer, or an SiNₓ layer, which are insulating light-transmitting dielectric layers.

7. The photonic-crystal surface-emitting laser element according to any one of claims 1 to 5,
wherein the high-refractive-index layer includes at least one semiconductor layer of a GaN layer, an AlGaN layer, an InGaN layer, an AlInGaN layer, or an AlN layer, and
the at least one semiconductor layer is insulating or of a conductive type opposite to the second semiconductor layer.
